# FASCICULE DE BREVET EUROPEEN

(11) **EP 2 610 906 B1**
(45) Date de publication et mention de la délivrance du brevet: **06.08.2014**
(21) Numéro de dépôt: 12196217.9
(22) Date de dépôt: 10.12.2012
(51) Int. Cl.: H01L 21/98, H01L 25/10, H05K 3/00

(54) **Procédé de fabrication collective de modules électroniques 3D ne comportant que des circuits imprimés validés**
Verfahren zur kollektiven Herstellung von 3D-Elektronikmodulen, die nur defektfreie Leiterplatten umfassen
Method for collective production of 3D electronic modules comprising only valid PCBs

(30) Priorité: 29.12.2011 FR 1104146
(43) Date de publication de la demande: 03.07.2013
(73) Titulaire: 3D Plus, 78530 Buc (FR)
(72) Inventeur: Val, Christian, 78470 St Remy Les Chevreuse (FR)
(74) Mandataire: Henriot, Marie-Pierre

(56) Documents cités:
- EP-A1- 2 053 646
- FR-A1- 2 857 157
- US-A1- 2007 045 875
- US-A1- 2008 284 037
- US-A1- 2008 308 921
- US-A1- 2009 039 526
- US-A1- 2009 321 957
- US-A1- 2010 261 311

## Description

Le domaine de l'invention est celui de la fabrication de modules électroniques 3D.

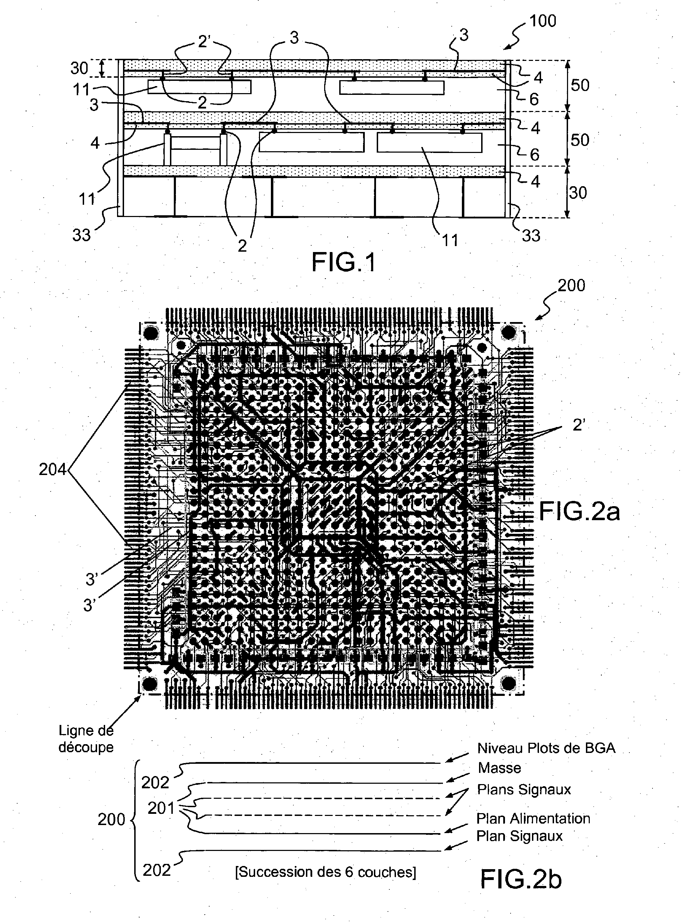

Un module électronique 3 D dont un exemple est représenté figure 1, comprend un empilement 100 de tranches électroniques 50 dont l'interconnexion s'effectue en trois dimensions en utilisant notamment les faces de l'empilement pour réaliser les connexions entre les tranches. Une tranche 50 comprend généralement un ou plusieurs composants 11 actifs et/ou passifs qui ont des éléments de connexion électrique 2, les composants étant enrobés dans une résine 6 électriquement isolante. Les éléments de connexion 2 des composants sont reliés à des plots de connexion 2' portés par un substrat électriquement isolant 4. Une ou plusieurs pistes 3 électriquement conductrices portées par le substrat isolant 4 relient ces composants entre eux ou les relient à des éléments de connexion électrique des tranches entre elles. Un module électronique 3D comprend au moins un composant actif dans une des tranches.

Ces tranches 50 ont de préférence été obtenues par fabrication collective, à partir de plaques (« wafers » en anglais) reconstituées aussi désignées KGRWs, acronyme de l'expression anglo-saxonne Known Good Reconstructed Wafers, elles-mêmes réalisées au cours des étapes suivantes :
A) Positionner et fixer sur un support des composants 11 nus (= non encapsulés) en silicium actifs et/ou passifs, munis de leurs plots de connexion 2, ces composants ayant été préalablement validés à l'issue d'un test ; les plots de connexion sont en contact avec le support. Ce support est typiquement une feuille adhésive du type peau collante.
B) Déposer sur l'ensemble des composants et du support, une couche polymère telle que de la résine époxy 6.
C) Retirer le support (la peau collante).
D) Redistribuer les plots pour connecter ensemble les composants 11 d'un même motif et/ou faire des connexions vers la périphérie du motif en vue d'une interconnexion 3D ultérieure. A cet effet on dépose une couche d'un matériau isolant 4 de type polymère gravable, sur laquelle sont formées des pistes conductrices métalliques 3 assurant la connexion du composant 11 vers d'autres composants et/ou vers la périphérie. Une couche d'isolant 4 est éventuellement déposée sur les pistes conductrices 3. Dans certains cas de connexions complexes, plusieurs couches d'isolant+métal+isolant éventuel (= niveau) peuvent être déposées les une sur les autres. On a alors réalisé une couche de redistribution 30 dite couche RDL à un ou plusieurs niveaux. Sur la figure la couche RDL de chaque tranche 50 a un seul niveau.
   On a ainsi obtenu une plaque reconstituée « KGRW » ne comportant donc que des composants préalablement testées et validées.
E) Plusieurs plaques KGRWs ayant été fabriquées, elles sont alors empilées.
F) Une couche 30 de redistribution des plots, dite RDL acronyme de l'expression anglo-saxonne ReDistribution Layer, est formée sur une des faces de l'empilement, formant ainsi la « première » couche de l'empilement. Cette couche RDL comporte typiquement de 1 à 4 niveaux (ou sous-couches) et est formée sur l'empilement de plaques avant l'étape de découpe, c'est-à-dire au cours du procédé de fabrication collective. Sur la figure elle comporte deux niveaux.

L'empilement de plaques est découpé pour obtenir des empilements 100 de tranches.

Des conducteurs 33 situés sur les faces latérales de l'empilement de tranches, c'est-à-dire sur les bords des tranches et éventuellement sur l'un des faces, et désignés conducteurs latéraux, sont formés pour relier électriquement les composants d'une tranche à l'autre.

Un exemple d'un tel procédé est décrit dans le brevet FR 2 857 157.

Or il est souvent nécessaire d'avoir pour une tranche 50 et/ou pour la première couche de l'empilement 100 de tranches, une couche de redistribution (RDL) de plus de 4 niveaux : 6 à 10 niveaux de connexion sont souvent nécessaires. Mais le rendement des couches RDL chute rapidement avec l'augmentation du nombre de niveaux. Pour une tranche, on passe typiquement d'un rendement de 96% avec une RDL à un niveau, à 80% pour une RDL à quatre niveaux ; on ne réalise donc pas de RDL à 6 niveaux ou plus.

En conséquence, il demeure à ce jour un besoin pour un procédé de fabrication collective de modules électroniques 3D donnant simultanément satisfaction à l'ensemble des exigences précitées, en termes de nombre de couches de redistribution et de rendement (nombre de validés/nombre de fabriqués).

Le principe de l'invention est :
- d'une part d'assurer la connexion électrique entre les tranches empilées d'un module électronique 3D (obtenues en utilisant les techniques de l'industrie des semi-conducteurs), par un circuit imprimé ou PCB acronyme de l'expression anglo-saxonne Printed Circuit Board, ce qui permet d'avoir plus de couches de connexion, et
- d'autre part d'obtenir les modules électroniques 3D par fabrication collective en utilisant un panneau de PCBs 100 % bons, ce qui permet d'augmenter le rendement global de la fabrication.

L'invention selon la revendication 1 a pour objet un procédé de fabrication collective de modules électroniques 3D qui comprend :
- une étape de fabrication d'un empilement de N plaques reconstituées (N>1) dites KGRWs, ne comportant chacune que des motifs identiques validés à l'issue d'un test électrique, un motif comportant au moins un composant actif et/ou passif en silicium, au moins une plaque reconstituée comportant des composants actifs, cet empilement incluant une couche de redistribution avec maximum 4 niveaux d'interconnexion,
   ce procédé comprenant en outre:
- une étape de fabrication d'un panneau de circuits imprimés passifs identiques ne comportant que des circuits imprimés passifs comportant au moins 6 niveaux d'interconnexion et validés à l'issue d'un test, qui comprend les sous-étapes suivantes :
   ∘ fabrication d'un panneau de circuits imprimés identiques, chaque niveau d'interconnexion étant obtenu par gravure de conducteurs de cuivre sur un support électriquement isolant constitué de résine epoxy contenant des fibres de verre,
   ∘ test électrique de chaque circuit imprimé,
   o report des circuits imprimés validés à l'issue de ce test sur un support adhésif,
   o moulage des circuits reportés dans une résine électriquement isolante de type époxy, dite résine d'enrobage et polymérisation de la résine,
   o retrait du support adhésif, un panneau ne comportant que des circuits imprimés validés, désigné panneau de KGRPs, étant ainsi obtenu à l'issue de cette étape,
- une étape de collage du panneau de KGRPs sur un empilement de KGRWs, pour former un ensemble « empilement de KGRWs-panneau de KGRPs »,
- une étape de découpe de l'ensemble « empilement de KGRWs-panneau de KGRPs » selon des lignes de découpe en vue d'obtenir les modules électroniques 3D.

Selon une caractéristique de l'invention, il comprend avant l'étape de collage, une étape de réalisation d'une couche de redistribution d'épaisseur inférieure à 30 µm, sur le panneau de KRGPs.

Les lignes de découpe sont de préférence au niveau de la résine d'enrobage.

L'ensemble « empilement de KGRWs- panneau KGRP » comportant dans son épaisseur au moins une zone électriquement isolante, il comprend éventuellement entre l'étape de collage du KRGP et l'étape de découpe, une étape de percement de trous dans ladite (ou lesdites) zone(s) électriquement isolante(s), et une étape de remplissage de ces trous avec un matériau électriquement conducteur.

Plusieurs empilements de KGRWs et/ou plusieurs panneaux KGRPs peuvent être fabriqués : avant l'étape de découpe, l'étape de collage d'un empilement de KGRWs avec un panneau de KGRPs est alors réitérée, l'ensemble « empilement de KGRWs-panneau de KGRPs » comportant plusieurs empilements de KGRWs et/ou plusieurs panneaux de KGRPs.

D'autres caractéristiques et avantages de l'invention apparaîtront à la lecture de la description détaillée qui suit, faite à titre d'exemple non limitatif et en référence aux dessins annexés dans lesquels :
la figure 1 déjà décrite représente schématiquement un exemple d'empilement de tranches d'un module électronique 3D selon l'état de la technique,
les figures 2a et 2b représentent schématiquement un exemple de PCB selon l'état de la technique, vu de dessus (fig 2a) et en coupe (fig 2b), les figures 3a - 3f illustrent différentes étapes de fabrication collective de modules électroniques 3D selon l'invention,
les figures 4a et 4b représentent schématiquement différents aspects de deux exemples de modules électroniques 3D obtenus par un procédé selon l'invention, l'un ayant été découpé avec la même structure de résine le long de la découpe (fig 4a), l'autre avec deux structures de résine différentes (fig 4b),
la figure 5 représente un exemple de PCB topologique vu en éclaté, selon l'état de la technique,
la figure 6 représente un exemple de PCB avec composants passifs reportés en surface, selon l'état de la technique.

D'une figure à l'autre, les mêmes éléments sont repérés par les mêmes références.

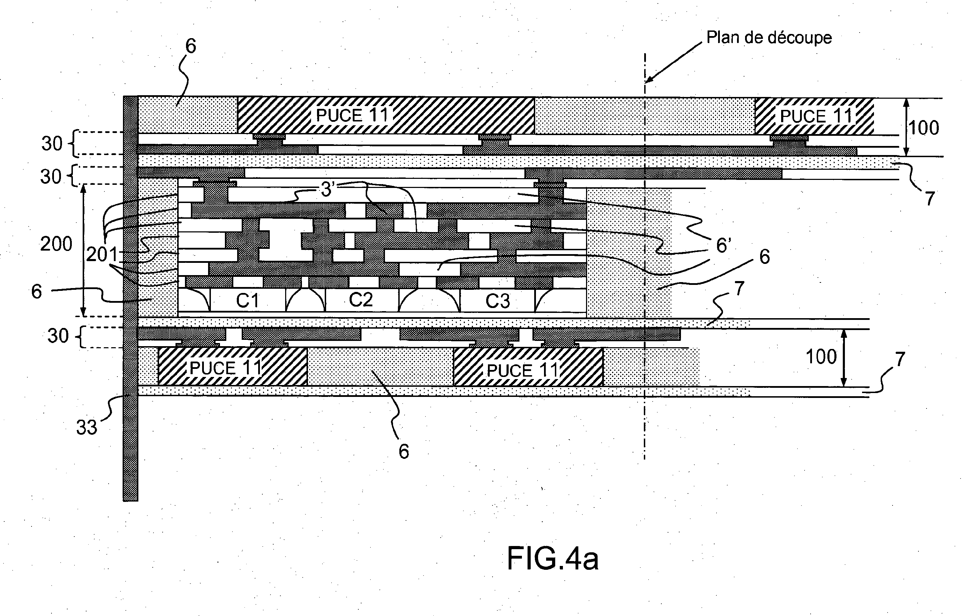

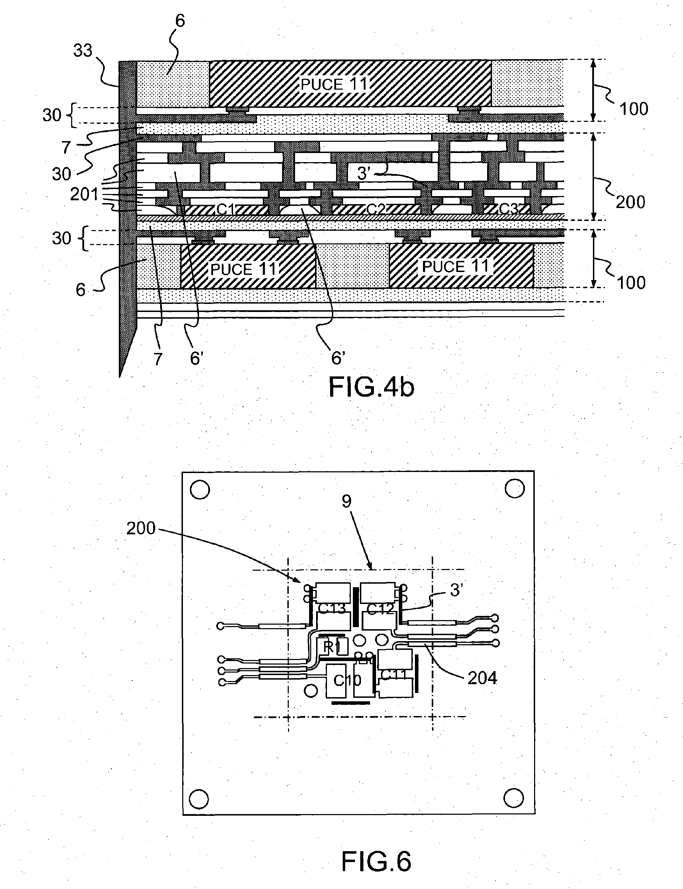

Un module électronique 3D obtenu par un procédé selon l'invention dont certains aspects sont montrés aux figures 4a et 4b, comprend au moins :
- un empilement de N tranches 50 N>1; cet empilement comportant au moins un composant actif est désigné empilement actif 100 et inclut une couche RDL 30 sur une face (ou les deux faces) de l'empilement, et
- un circuit imprimé ou PCB 200 assurant la connexion électrique entre les composants de ces tranches, ce PCB comportant au moins 6 niveaux d'interconnexion étant lui-même empilé sur ledit empilement 100.

Les échelles d'épaisseur ne sont pas respectées sur les figures.

Un PCB peut également être conçu pour assurer la connexion entre deux empilements actifs disposés l'un sur une face du PCB, l'autre sur l'autre face, comme on peut le voir sur l'exemple de module électronique 3D des figures 4a et 4b, où ne sont représentées qu'une seule tranche 50 de chaque empilement actif. Plus généralement, un module électronique 3D obtenu par un procédé selon l'invention comporte un ou plusieurs empilements actifs et un ou plusieurs PCBs.

Comme indiqué en préambule, les modules électroniques 3D (sans les conducteurs latéraux) sont obtenus après une étape de découpe des plaques empilées, l'empilement incluant en première couche, une couche RDL d'environ 30 µm d'épaisseur. On considère que l'empilement des plaques KGRWs a été réalisé en utilisant les technologies utilisées dans l'industrie des semi-conducteurs, selon un procédé de fabrication collective tel que rappelé en préambule et comportant les étapes successives A, B, C, D, E et F.

On s'attache à présent à la fabrication collective des circuits imprimés ou PCBs.

On rappelle qu'un circuit imprimé ou PCB acronyme de l'expression anglo-saxonne Printed Circuit Board, est un circuit de connexion électrique qui comporte des pistes électriquement conductrices et peut comporter des composants passifs tels que condensateurs C, résistances R, selfs. Un PCB comporte typiquement 50 à 150 condensateurs de découplage qui seront respectivement reliés aux composants actifs (aussi désignés puces) et/ou passifs de l'empilement actif.

Ces PCB 200 ont couramment plus de 6 niveaux (ou couches) comme montré figure 2b (avec 4 niveaux pour ne pas surcharger la figure), car ils sont également pourvus de plans de masse et d'alimentation iso potentiels pour chaque tension nécessaire, chaque plan formant un niveau. On rappelle qu'un PCB est constitué :
- de couches internes 201 réservées aux plans de masse et d'alimentation et comportant éventuellement des plans de routage de signaux, dont la superposition forme un panneau de couches internes,
- et généralement de couches externes 202 assurant le routage des signaux, prenant en sandwich ce panneau de couches internes, une fois que celui-ci est réalisé.

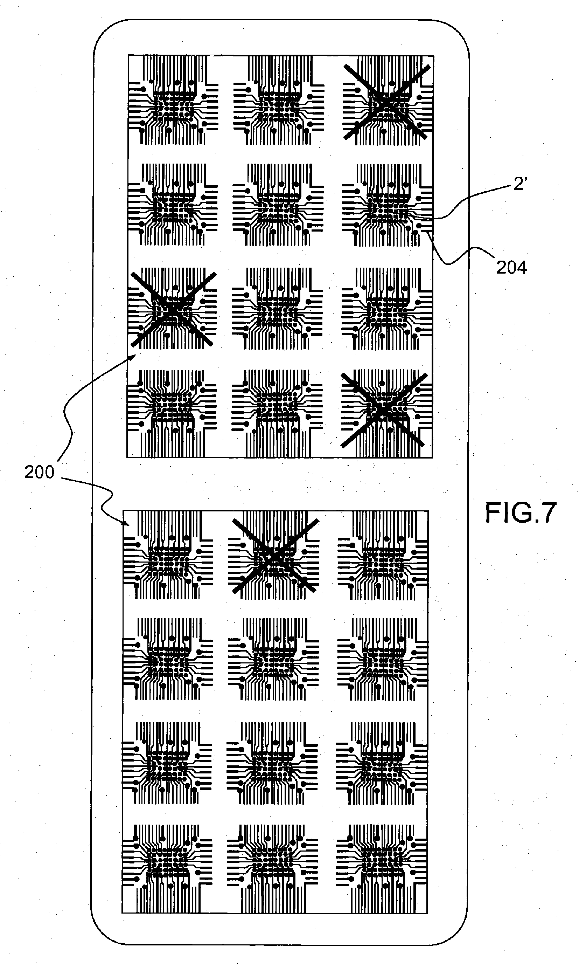

Le rendement du panneau de couches internes est compris entre 90% et 95% car seules des couches sélectionnées après avoir été testées et validées sont pressées entre elles pour former ce panneau. Mais le rendement des couches externes qui sont construites une à une sur le panneau de couches internes en fonction de la finesse de gravure requise, peut varier entre 75% et 90%. Le rendement global qui est le produit des rendements unitaires, est donc situé entre 70% et 85%. Un exemple de panneau (en deux parties) de PCBs 200 est montré figure 7 : 4 PCBs ont été considérés défectueux, soit un rendement de 83 %.

Ainsi pour la fabrication collective de modules 3D, le bénéfice lié à l'utilisation de KGRWs pour l'empilement actif avec un rendement proche de 100%, peut être perdu lorsque ces KGRWs sont empilées sur un panneau de PCBs dont certains sont défectueux. Ceci est d'autant plus préoccupant que la valeur des composants actifs est beaucoup plus élevée que celle des éléments passifs (les PCB). C'est pourquoi on va réaliser selon l'invention un panneau ne comportant que de bons PCBs, c'est-à-dire ne comportant que des PCBs validés à l'issue d'un test, et désigné KGRPs pour « Known Good Reconstructed PCBs ».

L'étape préalable consiste à réaliser de manière classique un panneau de PCBs comportant n motifs (ou PCBs) identiques, n variant typiquement de 20 à 1000 selon le format des panneaux et des motifs. On utilise pour la fabrication de ce panneau les techniques habituelles de fabrication des circuits imprimés, c'est-à-dire la photogravure d'une couche en cuivre préalablement déposée sur un support 6' électriquement isolant en résine époxy ; la constitution des circuits imprimés ne nécessite jamais l'usage de silicium . Cette couche de cuivre est laminée puis déposée par pressage sur le support, ce qui nécessite une épaisseur minimale à la fois pour la couche de cuivre et pour le support. L'épaisseur du cuivre est couramment de 5 µm à 25 µm ce qui limite la définition de la gravure des pistes 3'. En effet, plus l'épaisseur d'une couche devant être gravée chimiquement est épaisse, moins la définition est bonne en raison d'un phénomène de sous-gravure. Dans la pratique, on obtient des pas pour les conducteurs 3' supérieurs à 100 µm, typiquement compris entre 100 µm et 200 µm. On rappelle qu'un pas est la somme de la largeur d'un conducteur et de l'espace entre deux conducteurs 3'. Un pas de 100 µm = 50 µm (largeur conducteur) + 50 µm (espace entre deux conducteurs). L'épaisseur du support 6' varie entre 50 µm et 150 µm.

Pour réduire le coefficient de dilatation de la résine époxy constituant le support 6', celle-ci contient des fibres de verre ; c'est ainsi que ce coefficient passe de 60 à 80 ppm/°C pour de la résine seule à 15 à 18 ppm/°C avec les fibres de verre dans la résine. Par contre, le coefficient de dilatation en « Z » restera non modifié et sera compris entre 60 et 80 ppm/°C.

Les masques utilisés pour l'insolation sont en verre plan compte tenu des contraintes de planéité.

On obtient donc une épaisseur minimale de 75 µm par niveau de connexion (50 µm pour le support + 25 µm pour les pistes de cuivre). Les niveaux sont réalisés les uns sur les autres pour finalement former un panneau de PCBs d'au moins 750 µm d'épaisseur pour un PCB à 10 niveaux.

Alors qu'avec les technologies de photogravure utilisées pour la réalisation des KGRWs, le support 6 en résine chargée de microbilles qui est déposé sous forme liquide, a typiquement après polymérisation, une épaisseur comprise entre 10 µm et 15 µm et les pistes métalliques ont une épaisseur de l'ordre de 1 µm voire moins qui permet d'obtenir des pas inférieurs à 10 µm.

Chaque motif c'est-à-dire chaque PCB est ensuite testé électriquement, puis le panneau est découpé.

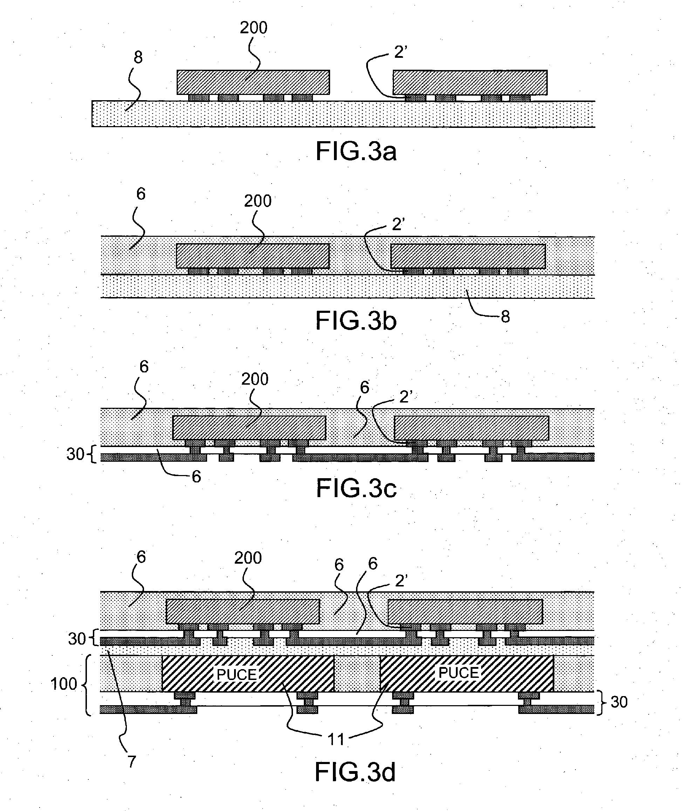

Au cours d'une étape suivante (étape a, fig 3a), les PCBs 200 validés à l'issue du test, sont reportés sur un support adhésif 8 par exemple par un procédé de type « pick and place », les plots d'interconnexion de chaque PCB étant côté support adhésif comme montré sur la figure. Ce support adhésif peut être une feuille adhésive comme par exemple une feuille en chlorure de polyvinyle, couramment appelée peau de tambour ou peau collante d'une épaisseur d'environ 25 µm et qui peut être décollée sans traitement particulier par pelage par exemple.

Lors d'une étape b (fig 3b), les PCBs 200 sont alors enrobés dans une résine électriquement isolante 6 du même type que celle utilisée pour réaliser les KGRWs (résine Epoxy par exemple), qui est ensuite polymérisée.

Cette résine 6 est chargée de billes en silice qui permettent de réduire son coefficient de dilatation en X, Y et Z (dans les trois directions spatiales) : elle est isotrope. Alors que les fibres de verre présentes dans le substrat 6' du PCB ne permettent de réduire le coefficient de dilatation du substrat qu'en X et Y, et présentent en outre des inconvénients en termes de courants de fuite, lors de l'étape ultérieure de réalisation des conducteurs 33 sur les faces latérales de chaque module 3D comme décrit plus loin. Dans ce cas, l'enrobage des PCBs a en plus de la fonction habituelle de fixer le positionnement de chaque PCB sur la peau collante, une fonction d'isolation des fibres de verre de chaque couche au niveau des futures lignes de découpe, pour reconstituer par construction un panneau de PCBs ayant au niveau de ces lignes de découpe la même structure que les KGRWs sur lesquels il sera empilé et ainsi éviter ces courants de fuite.

Une fois les PCBs enrobés, la peau collante 8 est retirée.

On a alors obtenu un panneau ne comportant que des PCBs validés, désigné panneau de KGRPs, c'est-à-dire un panneau dont le rendement est 100%.

Une RDL 30 à un niveau est réalisée sur la face extérieure du panneau de PCBs (étape c, fig 3c) pour réaliser des connexions vers la périphérie de chaque PCB 200. Cela permet de réaliser une couche de très grande précision en utilisant cette fois les techniques utilisées pour fabriquer les plaques (« wafers ») ; on peut ainsi réaliser en surface du panneau provisoire, des pistes conductrices à faible pas, c'est-à-dire inférieur à 100 µm. Un pas de 10 µm peut être envisagé avec ces techniques. Cela permet d'améliorer le rendement intrinsèque du panneau de KGRPs ainsi obtenu.

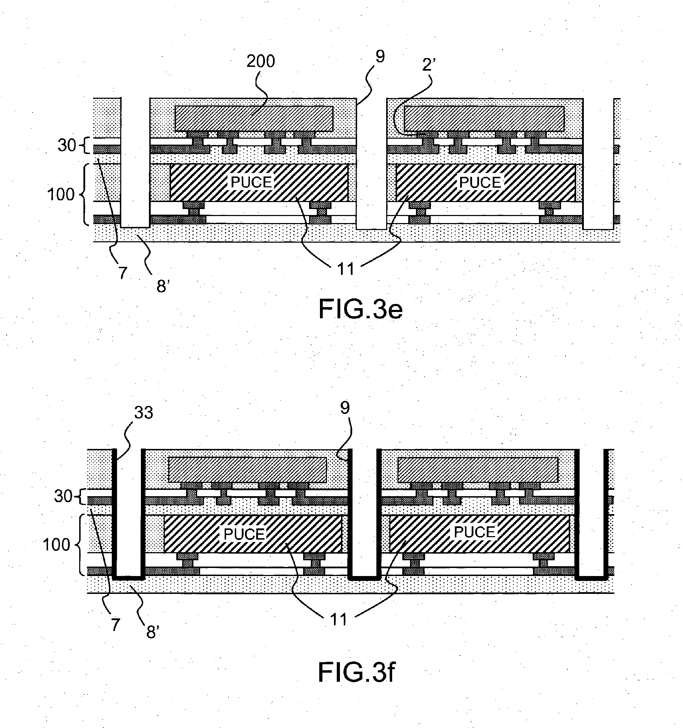

Ce panneau de KGRPs pourvu d'une RDL est alors lui-même collé sur l'empilement de plaques KGRWs (fig 3 d) au moyen d'une colle 7 liquide de préférence, par exemple de type époxy.

De préférence, selon une variante on ne construit pas les couches externes 202 lors de la fabrication du panneau PCB d'origine (étape préalable) qui ne comporte donc que les couches internes 201. Un panneau provisoire de KGRPs ne comportant que de bons motifs, est reconstitué comme indiqué précédemment. Les couches externes 202 sont alors remplacées par la réalisation d'une couche RDL (éventuellement à plusieurs niveaux) en surface du panneau provisoire de KGRPs (étape c), cette RDL 30 étant réalisée comme indiqué précédemment. Cela permet d'améliorer le rendement intrinsèque du panneau de KGRPs ainsi obtenu.

Ce panneau de KGRPs muni d'une couche RDL est alors lui-même collé sur un empilement 100 de plaques KGRWs (étape d, fig 3d) au moyen d'une colle 7 liquide de préférence, par exemple de type époxy, et forme ainsi un ensemble « empilement de KGRWs-panneau de PCBs ».

Eventuellement, un autre empilement de KGRWs est collé au panneau KGRP, ce dernier étant donc entre deux empilements de KGRWs. Plus généralement un ensemble « empilement de KGRWs-panneau de PCBs » peut comporter plusieurs empilements KGRWs et/ou plusieurs panneaux KGRPs, successivement collés les uns aux autres, comme dans l'exemple de la figure 4a.

Les futurs modules 3D sont découpés (étape e, fig 3e) le long de lignes de découpe verticale 9 (selon la direction de l'empilement) puis les conducteurs latéraux 33 sont alors formés sur les faces latérales (étape f, fig 3f). De préférence avant l'étape de découpe, une peau collante 8' est déposée sous l'ensemble « empilement de KGRWs-panneau de PCBs », de manière à pouvoir réaliser de manière collective, l'étape de métallisation des futures faces latérales (étape f). Cette peau collante est retirée pour obtenir les modules 3D.

Lorsque les lignes de découpe 9 traversent la résine à fibres de verre 6' (comme on peut le voir sur l'exemple de la figure 4b), les sections de ces fibres apparaissent sur les faces latérales du module électronique 3D avant réalisation des conducteurs latéraux. Lors de la métallisation chimique pour réaliser ces conducteurs latéraux 33, il y a alors une légère pénétration de la métallisation le long des ces fibres, ce qui conduit à des courants de fuite après gravure. Le comportement des résines chargées de billes de silice 6 ne présente pas cet inconvénient puisqu'il n'y a pas de continuité entre les microbilles. En décalant les lignes de découpe 9 jusqu'au niveau de la résine d'enrobage 6, les sections de ces fibres n'apparaissent pas sur les faces latérales du module électronique 3D avant réalisation des conducteurs latéraux comme montré figure 4a.

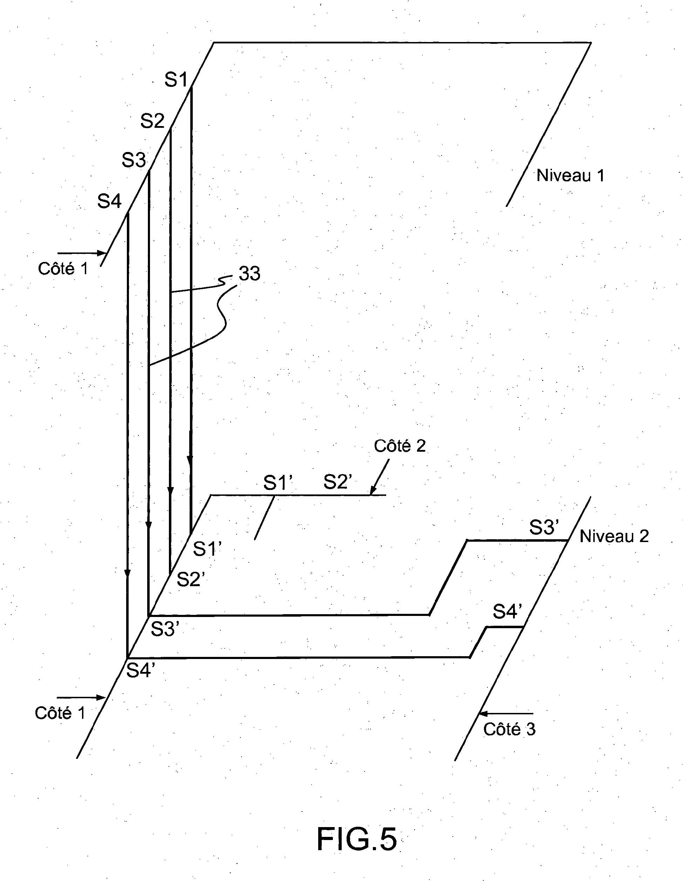

On distingue plusieurs catégories de PCBs, certaines pouvant favorablement tirer profit de cette variante :
- PCB pour connexion externe. Un exemple de routage d'un tel PCB à 6 couches (il pourrait facilement y en avoir 10) est montré figure 2a. Sur la partie centrale, on observe des plots matriciels 2' destinés à recevoir les billes de brasure d'un composant actif. Les 4 côtés portent des conducteurs perpendiculaires à chacun d'eux et qui, après empilage des différentes couches seront sectionnés selon la ligne de découpe : ces conducteurs ont alors la référence 204. Ces conducteurs ont des pas compris entre 100 µm et 200 µm par exemple. La réalisation de pas inférieurs à 100 µm n'étant actuellement pas réalisable industriellement avec un rendement acceptable, la réalisation d'une couche RDL selon la variante est extrêmement intéressante.
- PCB topologique qui permet de ramener une interconnexion sortant sur 1 ou 2 côtés pour un niveau 1, à une interconnexion sortant sur d'autres côtés pour un autre niveau 2 par exemple. La figure 5 présente un exemple d'interconnexion du niveau 1 ayant les sorties S1 à S4 sur un côté, avec le niveau 2 qui redistribue ces sorties sur deux côtés : les sorties S1' et S2' sont redistribuées sur le côté 2, et les sorties S3' et S4' sont redistribuées sur le côté 3.
- PCB avec composants passifs (condensateurs et/ou résistances et/ou selfs) généralement en céramique reportés en surface. La figure 6 présente un exemple de PCB vu de dessus avec 5 composants passifs reportés : une résistance R et 4 condensateurs C. Dans cet exemple le pas des conducteurs 3' et 204 est élevé. Il peut fortement diminuer avec une plus grande densité de composants passifs comme par exemple 200 condensateurs dans le cas d'un découplage d'une puce FPGA acronyme de l'expression anglo-saxonne « Field Programmable Gate Array » pour laquelle des plans de masse et d'alimentation iso potentiels seront nécessaires pour alimenter ces condensateurs, les sorties latérales ou des sorties par des trous traversants (TPV acronyme de l'expression anglo-saxonne « Through Polymer Vias ») nécessitant alors un niveau de RDL.
- PCB avec composants passifs en céramique enterrés dans ce PCB. Ce cas est identique au précédent mais avec des composants passifs enterrés dans le PCB. Une couche RDL permet de remplacer les conducteurs sur les côtés (ou les trous traversants) de chaque motif.

Quelle que soit la catégorie de PCB, ceux-ci ne comportent pas de silicium.

Certains empilements actifs qui comportent des processeurs rapides ou à grand nombre d'entrées-sorties, ou encore des mémoires rapides à large bus, nécessitent plusieurs tensions d'alimentation et une distribution des courants électriques quasiment sans inductance de façon à ne pas retarder l'établissement du niveau adéquat de tension.

Une solution existante consiste à réaliser des trous traversants TSV acronyme de l'expression anglo-saxonne « Through Silicium Vias », dans les puces et à les interconnecter verticalement, ce chemin vertical étant plus court que celui passant par les côtés du module 3D. Toutefois, le problème des alimentations avec le découplage approprié, nécessite l'utilisation de condensateurs les plus proches possible des puces.

Selon l'invention, le panneau de KGRPs est disposé sur l'empilement de KGRWs pour que la RDL de l'empilement des KGRWs soit face à la RDL du panneau de PCBs. On peut aussi procéder de la manière suivante. Après l'étape de collage et avant l'étape de découpe, des trous traversant l'ensemble « empilement de KGRWs- panneau KGRP » sont percés au niveau de la résine et remplis d'un matériau électriquement conducteur tel que le cuivre en utilisant des techniques de PCB. Cela permet de connecter le plan d'alimentation dans le PCB et le plot d'alimentation de la puce par des TPV, ce qui conduit à une distance comprise entre 75 µm et 200 µm, ce qui reste très faible. Cet ensemble ainsi connecté peut lui-même être empilé sur d'autres empilements de KGRWs et/ou d'autres panneaux de PCBs, avant d'être découpé. L'interconnexion par les conducteurs latéraux 33 est alors réservée aux signaux.

## Revendications

1. Procédé de fabrication collective de modules électroniques 3D qui comprend :
- une étape de fabrication d'un empilement (100) de N plaques reconstituées, avec N>1, dites KGRWs ne comportant chacune que des motifs identiques validés à l'issue d'un test électrique, un motif comportant au moins un composant (11) actif et/ou passif en silicium, au moins une plaque reconstituée comportant des composants actifs, cet empilement (100) incluant une couche de redistribution (30) avec maximum 4 niveaux d'interconnexion,
le procédé comprenant en outre:
- une étape de fabrication d'un panneau de circuits imprimés passifs identiques ne comportant que des circuits imprimés passifs (200) comportant au moins 6 niveaux d'interconnexion et validés à l'issue d'un test, qui comprend les sous-étapes suivantes :
∘ fabrication d'un panneau de circuits imprimés (200) identiques, chaque niveau d'interconnexion étant obtenu par gravure de conducteurs (3') de cuivre sur un support électriquement isolant constitué de résine époxy (6') contenant des fibres de verre,
∘ test électrique de chaque circuit imprimé (200),
∘ report des circuits imprimés validés à l'issue de ce test sur un support adhésif (8),
∘ moulage des circuits reportés dans une résine électriquement isolante de type époxy (6), dite résine d'enrobage et polymérisation de la résine,
∘ retrait du support adhésif (8), un panneau ne comportant que des circuits imprimés validés (200), désigné panneau de KGRPs, étant ainsi obtenu à l'issue de cette étape,
- une étape de collage du panneau de KGRPs avec un empilement (100) de KGRWs, pour former un ensemble « empilement de KGRWs-panneau KGRPs»,
- une étape de découpe de l'ensemble « empilement de KGRWs-panneau KGRPs» selon des lignes de découpe (9) en vue d'obtenir les modules électroniques 3D.

2. Procédé de fabrication collective de modules électroniques 3D selon la revendication précédente, **caractérisé en ce qu'**il comprend avant l'étape de collage du panneau de KRGPs avec un empilement de KGRWs, une étape de réalisation d'une couche de redistribution (30) d'épaisseur inférieure à 30 µm, sur le panneau de KRGPs.

3. Procédé de fabrication collective de modules électroniques 3D selon la revendication précédente, **caractérisé en ce que** les lignes de découpe (9) sont au niveau de la résine d'enrobage (6).

4. Procédé de fabrication collective de modules électroniques 3D selon la revendication 1, **caractérisé en ce que** l'ensemble « empilement de KGRWs- panneau KGRP » comportant dans son épaisseur au moins une zone électriquement isolante, il comprend entre l'étape de collage et l'étape de découpe, une étape de percement de trous dans ladite (ou lesdites) zone(s) électriquement isolante(s), et une étape de remplissage de ces trous avec un matériau électriquement conducteur.

5. Procédé de fabrication collective de modules électroniques 3D selon l'une des revendications précédentes, **caractérisé en ce que** plusieurs empilements (100) de KGRWs et/ou plusieurs panneaux KGRPs sont fabriqués et **en ce qu'**avant l'étape de découpe, l'étape de collage d'un empilement de KGRWs avec un panneau de KGRPs est réitérée, l'ensemble « empilement de KGRWs-panneau de KGRPs » comportant plusieurs empilements de KGRWs et/ou plusieurs panneaux de KGRPs.

6. Procédé de fabrication collective de modules électroniques 3D selon l'une des revendications précédentes, **caractérisé en ce qu'**un circuit imprimé comporte une résistance (R) et/ou un condensateur (C) et/ou une self.

## Patentansprüche

1. Verfahren zum kollektiven Herstellen von elektronischen 3D-Modulen, das Folgendes beinhaltet:
- einen Schritt des Herstellens eines Stapels (100) von N rekonstituierten Wafern, KGRWs genannt, wobei N>1 ist, die jeweils nur identische Muster umfassen, die nach einem elektrischen Test validiert werden, wobei ein Muster wenigstens eine aktive und/oder passive Komponente (11) aus Silicium umfasst, wobei wenigstens ein rekonstituierter Wafer aktive Komponenten umfasst, wobei der Stapel (100) eine Umverteilungsschicht (30) mit maximal 4 Verbindungsebenen beinhaltet,
wobei das Verfahren ferner Folgendes beinhaltet:
- einen Schritt des Herstellens einer Platine von identischen passiven gedruckten Schaltungen, die nur passive gedruckte Schaltungen (200) umfassen, die wenigstens 6 Verbindungsebenen umfassen und nach einem Test validiert werden, wobei dieser Schritt die folgenden Teilschritte beinhaltet:
∘ Herstellen einer Platine von identischen gedruckten Schaltungen (200), wobei jede Verbindungsebene durch Ätzen von Kupferleitern (3') auf einem elektrisch isolierenden Substrat aus einem Epoxidharz (6') erhalten wird, das Glasfasern enthält;
∘ elektrisches Prüfen jeder gedruckten Schaltung (200);
∘ Übertragen von gedruckten Schaltungen, die nach diesem Test validiert wurden, auf ein klebendes Substrat (8);
∘ Formen von übertragenen Schaltungen in einem elektrisch isolierenden Harz des Epoxidtyps (6), Beschichtungsharz genannt, und Polymerisieren des Harzes;
∘ Abziehen des klebenden Substrats (8), wobei eine Platine nur validierte gedruckte Schaltungen (200) umfasst, KGRP-Platinen genannt, die somit nach diesem Schritt erhalten werden;
- einen Schritt des Klebens der KGRP-Platine auf einen Stapel (100) von KGRWs, um eine Baugruppe aus "KGRW-Stapel und KGRP-Platine" zu bilden;
- einen Schritt des Zerschneidens der Baugruppe aus "KGRW-Stapel und KGRP-Platine" entlang Schnittlinien (9), um die elektronischen 3D-Module zu erhalten.

2. Verfahren zum kollektiven Herstellen von elektronischen 3D-Modulen nach dem vorherigen Anspruch, **dadurch gekennzeichnet, dass** es vor dem Schritt des Klebens der KGRP-Platine auf einen KGRW-Stapel einen Schritt des Produzierens einer Umverteilungsschicht (30) mit einer Dicke von weniger als 30 µm auf der KGRP-Platine beinhaltet.

3. Verfahren zum kollektiven Herstellen von elektronischen 3D-Modulen nach dem vorherigen Anspruch, **dadurch gekennzeichnet, dass** sich die Schnittlinien (9) auf dem Beschichtungsharz (6) befinden.

4. Verfahren zum kollektiven Herstellen von elektronischen 3D-Modulen nach Anspruch 1, **dadurch gekennzeichnet, dass** die Baugruppe aus "KGRW-Stapel und KGRP-Platine", wenn ihre Dicke wenigstens eine elektrisch isolierende Zone beinhaltet, zwischen dem Klebeschritt und dem Schneidschritt einen Schritt des Perforierens der ein oder mehreren elektrisch isolierenden Zonen und einen Schritt des Füllens dieser Löcher mit einem elektrisch leitenden Material beinhaltet.

5. Verfahren zum kollektiven Herstellen von elektronischen 3D-Modulen nach einem der vorherigen Ansprüche, **dadurch gekennzeichnet, dass** mehrere KGRW-Stapel (100) und/oder mehrere KGRP-Platinen hergestellt werden, und dadurch, dass vor dem Schneidschritt der Schritt des Klebens eines KGRW-Stapels auf eine KGRP-Platine wiederholt wird, wobei die Baugruppe aus "KGRW-Stapel und KGRP-Platine" mehrere KGRW-Stapel und/oder mehrere KGRP-Platinen umfasst.

6. Verfahren zum kollektiven Herstellen von elektronischen 3D-Modulen nach einem der vorherigen Ansprüche, **dadurch gekennzeichnet, dass** eine gedruckte Schaltung einen Widerstand (R) und/oder einen Kondensator (C) und/oder einen Induktor umfasst.

## Claims

1. A method for the collective production of 3D electronic modules, comprising:
- a step of producing a stack (100) of N reconstructed wafers, with N>1, referred to as KGRWs, each comprising only identical patterns validated on completion of an electrical test, with a pattern comprising at least one active and/or passive component (11) made of silicon, at least one reconstructed wafer comprising active components, said stack (100) including a redistribution layer (30) with a maximum of 4 interconnection levels,
said method further comprising:
- a step of producing a board of identical passive printed circuits comprising only passive printed circuits (200) comprising at least 6 interconnection levels and validated on completion of a test, which step comprises the following sub-steps:
∘ producing a board of identical printed circuits (200), with each interconnection level being obtained by etching copper conductors (3') on an electrically isolating support made of epoxy resin (6') containing glass fibres;
∘ electrically testing each printed circuit (200);
∘ placing printed circuits, validated on completion of said test, on an adhesive support (8);
∘ moulding transferred circuits in an electrically isolating resin of the epoxy (6) type, referred to as coating resin, and polymerising said resin;
∘ withdrawing said adhesive support (8), with a board only comprising validated printed circuits (200), referred to as KGRPs boards, thus being obtained on completion of this step;
- a step of bonding the board of KGRPs to a stack (100) of KGRWs so as to form a "KGRWs stack-KGRPs board" assembly;
- a step of cutting said "KGRWs stack-KGRPs board" assembly along cutting lines (9) so as to obtain said 3D electronic modules.

2. The method for the collective production of 3D electronic modules according to the preceding claim, **characterised in that** it comprises, prior to said step of bonding said board of KGRPs with a stack of KGRWs, a step of producing a redistribution layer (30), the thickness of which is less than 30 µm, on said board of KGRPs.

3. The method for the collective production of 3D electronic modules according to the preceding claim, **characterised in that** said cutting lines (9) are on the coating resin (6).

4. The method for the collective production of 3D electronic modules according to claim 1, **characterised in that**, with the thickness of said "KGRWs stack-KGRPs board" assembly comprising at least one electrically isolating zone, it comprises, between said bonding step and said cutting step, a step of perforating holes in said one or more electrically isolating zone(s), and a step of filling said holes with an electrically conducting material.

5. The method for the collective production of 3D electronic modules according to any one of the preceding claims, **characterised in that** a plurality of stacks (100) of KGRWs and/or a plurality of KGRPs boards is produced, and **in that**, before said cutting step, said step of bonding a stack of KGRWs with a board of KGRPs is repeated, with said "KGRWs stack-KGRPs board" assembly comprising a plurality of stacks of KGRWs and/or a plurality of KGRPs boards.

6. The method for the collective production of 3D electronic modules according to any one of the preceding claims, **characterised in that** a printed circuit comprises a resistor (R) and/or a capacitor (C) and/or an inductor.
